# DEMANDE DE BREVET EUROPEEN

(11) **EP 4 759 963 A1**
(43) Date de publication de la demande: **17.06.2026**
(21) Numéro de dépôt: 24220357.8
(22) Date de dépôt: 16.12.2024
(51) Int. Cl.: C23C 16/30, C23C 16/455, B05D 1/00, G04B 13/02, G04B 15/14, G04B 19/12, G04D 3/00

(54) **COMPOSANT HORLOGER AVEC COUCHE FONCTIONNELLE**

(71) Demandeur: RICHEMONT INTERNATIONAL SA, 1752 Villars-sur-Glâne (CH)
(72) Inventeur: FERSING, Guillaume, 68000 Colmar (FR); NOIRAUD, Guilhem, 2300 La-Chaux-de-Fonds (CH); GAUTIER, Cyrille, 2300 La-Chaux-de-Fonds (CH)
(74) Mandataire: LLR

(57) **Abrégé**

L'invention se rapporte à un composant horloger (1) formé d'un substrat (10) qui est au moins partiellement recouvert par un revêtement (20) comportant au moins une couche (20A) fonctionnelle, déposée par méthode MLD, à base d'un matériau organique afin d'améliorer la durabilité dudit revêtement (20).

## Description

### DOMAINE TECHNIQUE DE L'INVENTION

La présente invention se rapporte à un procédé de dépôt d'une couche fonctionnelle sur le corps d'une ébauche de composant horloger et au composant horloger ainsi obtenu comportant la couche fonctionnelle.

### ARRIÈRE-PLAN TECHNIQUE DE L'INVENTION

En horlogerie, des composants sont souvent métallisés à des fins esthétiques. Par exemple, une grande partie des cadrans produits présente une finition argentée obtenue par le dépôt d'une couche en argent pur par galvanoplastie sur un substrat ou par une pièce en argent massif dans certains cas. Chaque partie métallique de composants peut être protégée par exemple par un revêtement d'alumine déposé par une méthode ALD (venant des termes anglais « Atomic Layer Déposition ») sur la partie métallique. En effet, la couche d'alumine permet de recouvrir la partie métallique pour la protéger et éventuellement de modifier la couleur du composant par effet interférentiel.

Toutefois, ces revêtements déposés par méthode ALD présentent des inconvénients. Ainsi, ils ne permettent pas d'obtenir une adhérence de l'alumine sur la couche métallique apte à satisfaire aux tests de vieillissement tels notamment que le « test du scotch », ce qui engendre un risque de qualité peu compatible avec des applications de transmission de force. Par ailleurs, l'adhérence du revêtement ALD est également problématique avec les revêtements supérieurs tels que des laques décoratives qui apportent de la profondeur à la couleur. Enfin, les revêtements ALD sont relativement rigides et cassants au point d'être inapplicables sur des composants horlogers utilisés en déformation (traction, compression, flexion, etc.). Ces revêtements déposés par méthode ALD ne permettent donc pas de garantir une protection durable au cours du temps.

À titre d'exemple, comme indiqué dans le document WO 2014/006229, on doit généralement limiter l'épaisseur maximale d'un revêtement ALD sur un spiral horloger afin de minimiser le risque de fissuration du revêtement à cause des contraintes résiduelles crées à l'interface substrat - revêtement lors du dépôt.

### RÉSUMÉ DE L'INVENTION

L'invention a pour but de proposer un nouveau composant horloger et un procédé de fabrication du nouveau composant horloger comportant un revêtement avec une bonne adhérence sur un très grand nombre de matériaux (« test du scotch » positif), une flexibilité apte à maintenir un encapsulage efficace même sur un composant horloger utilisé en déformation et pouvant apporter de nouvelles fonctionnalités tout en maintenant un dépôt de faible épaisseur selon une précision de l'ordre du nanomètre pour des applications notamment optiques et décoratives.

À cet effet, dans un premier mode de réalisation, l'invention a pour objet un composant horloger formé d'un substrat qui est au moins partiellement recouvert par un revêtement, caractérisé en ce que ledit revêtement comporte au moins une couche fonctionnelle, déposée par méthode MLD, à base d'un matériau organique afin d'améliorer la durabilité dudit revêtement.

Dans un deuxième mode de réalisation, l'invention a pour objet un composant horloger formé d'un substrat qui est au moins partiellement recouvert par un revêtement, caractérisé en ce que ledit revêtement comporte au moins une couche hybride, déposée par méthode hybride MLD/ALD, à base d'un matériau organique et d'un matériau inorganique afin d'améliorer la durabilité dudit revêtement.

La présence de fissures dans un dépôt et de manque d'étanchéité peut se mesurer avec le taux de transmission de la vapeur d'eau (parfois abrégé « WVTR » venant des termes « Water Vapour Transmission Rate »). Plus ce taux est élevé, plus le dépôt présente des failles, bris B ou porosités dans lesquelles la vapeur d'eau peut s'infiltrer. Le taux de transmission de la vapeur d'eau d'un dépôt d'alumine par méthode ALD se situe entre 10⁻³ et 10⁻⁴ g·m⁻²·j⁻¹ alors qu'un dépôt de ladite au moins une couche fonctionnelle par méthode MLD ou méthode hybride MLD/ALD selon l'invention a permis d'obtenir un taux de transmission de la vapeur d'eau compris entre 10⁻⁵ à 10⁻⁶ g·m⁻²·j⁻¹. On comprend donc que le composant horloger selon l'invention pour une application statique apporte déjà une nette amélioration en termes d'étanchéité.

L'avantage du composant horloger selon l'invention est encore plus marqué pour une application avec déformations tel qu'un ressort, un ressort-spiral, un sautoir, un cliquet ou un levier. En effet, après un travail en déformation (flexion, torsion, etc.), la couche d'alumine déposée par méthode ALD étant très rigide, le taux de transmission de la vapeur d'eau augmente sensiblement entre 10⁻² et 10⁻³ g·m⁻²·j⁻¹. De manière avantageuse, dans une telle situation, un dépôt de couche organique par méthode MLD ou de couche hybride par méthode hybride MLD/ALD selon l'invention a permis de maintenir un taux de transmission de la vapeur d'eau sensiblement stable, c'est-à-dire compris entre 10⁻⁵ à 10⁻⁶ g·m⁻²·j⁻¹. Cela démontre l'avantage du revêtement selon l'invention qui reste plus stable et plus étanche même lors de sollicitations mécaniques.

Ainsi, avantageusement selon l'invention, la flexibilité du revêtement évite l'accumulation de contraintes internes même en dépôts cumulés de grande épaisseur, c'est-à-dire typiquement supérieure à 100 nm, ce qui garantit une haute durabilité. En effet, les risques de délamination (« test du scotch » positif) et de bris notamment à cause des contraintes internes accumulées dans le revêtement sont limitées voire éliminées par l'invention même sur un composant horloger utilisé en déformation tel qu'un ressort, un ressort-spiral, un sautoir, un cliquet ou un levier. Par la nature gazeuse des précurseurs utilisés par méthode MLD ou méthode hybride MLD/ALD, avantageusement selon l'invention, le revêtement va être homogène et possiblement sur toute la surface externe du substrat, y compris dans des évidements borgnes. On comprend donc que le revêtement selon l'invention permet notamment une protection efficace contre le ternissement des matériaux du substrat tels que l'argent ou plus généralement offre une barrière mécanique et chimique efficace.

En outre, les molécules de ladite au moins une couche fonctionnelle ou de ladite au moins une couche hybride déposées à l'échelle nanométrique peuvent également contribuer à générer des couleurs par phénomène interférentiel. Enfin, les molécules de ladite au moins une couche fonctionnelle ou de ladite au moins une couche hybride peuvent être sélectionnées par rapport à l'interface prévue (substrat et / ou couche déposée au-dessous et / ou couche déposée par-dessus) pour former des liaisons covalentes comme, par exemple, avec une couche à base d'argent (Ag, couche au-dessous), un vernis ou une laque (couche au-dessus) afin d'améliorer, avantageusement selon l'invention, l'adhérence du revêtement.

L'invention peut également comporter l'une ou plusieurs des caractéristiques optionnelles suivantes, prises seules ou en combinaison.

Le matériau organique doit s'entendre comme formé d'au moins une molécule organique et / ou organométallique. Un tel matériau organique peut comporter une chaîne avec au moins deux atomes de carbone afin d'apporter une flexibilité au revêtement. Bien entendu, plus la chaîne sera longue, plus elle sera flexible. Préférentiellement, le matériau organique comporte entre 4 et 30 atomes de carbone par chaîne et encore plus préférentiellement entre 5 et 10 atomes de carbone par chaîne.

Bien entendu, chaque chaîne peut comporter au moins un hétéroatome tel que du soufre (S), de l'oxygène (O) ou de l'azote (N). En outre, chaque chaîne peut comporter au moins un cycle aromatique et / ou aliphatique. Enfin, chaque chaîne peut être saturée ou non et / ou comporter une structure linéaire ou non (par exemple trois, quatre ou cinq banches permettant d'ajouter des fonctionnalités chimiques).

Le matériau organique ou le matériau hybride comporte préférentiellement au moins un site fonctionnel sur au moins une terminaison (préférentiellement un à chaque extrémité) afin d'apporter une fonction d'adhérence et / ou de compatibilité avec un matériau au-dessus et / ou au-dessous, et / ou de modification de tension de surface et / ou de modification de la chimie de surface.

Selon un exemple, ledit au moins un site fonctionnel peut comporter une polyurée, une glycine, un glucose, un alcane, un alcool, un acide carboxylique, un organosilane, une organosilicone ou un composé perfluoré afin de former un revêtement hydrophile, hydrophobe et / ou lipophobe. Cette spécialisation du revêtement peut être par exemple utilisée comme épilame ou pour augmenter les qualités tribologiques.

Le revêtement peut comporter en outre au moins une couche mécanique, déposée par méthode ALD, à base d'un matériau inorganique afin d'améliorer la résistance mécanique et / ou la qualité optique dudit revêtement. On comprend que ladite au moins une couche fonctionnelle ou ladite au moins une couche hybride va éventuellement se déformer pour limiter voire éviter toute détérioration de ladite au moins une couche mécanique tout en maintenant l'encapsulation du substrat (étanchéité, adhérence, etc.) et éventuellement en améliorant l'adhérence que possède ladite au moins une couche mécanique par rapport au substrat (si le dépôt avait été réalisé directement dessus).

Le revêtement peut comporter plusieurs couches fonctionnelles et / ou plusieurs couches hybrides et / ou plusieurs couches mécaniques. Préférentiellement, ladite au moins une couche fonctionnelle ou hybride et ladite au moins une couche mécanique sont alternativement déposées. Toutefois, deux couches mécaniques (identiques ou non) et / ou deux couches fonctionnelles ou hybrides (identiques ou non) successives (l'une sur l'autre) peuvent être déposées. Suivant les applications envisagées, les épaisseurs de chaque couche (mécanique ou fonctionnelle) peuvent être sélectivement choisies.

Chaque couche mécanique peut être à base de céramique, c'est-à-dire à base d'un matériau (cristallin et/ou amorphe) à base d'un oxyde et / ou carbure et / ou sulfure et / ou nitrure.

Le composant horloger peut former un cadran, un spiral, une roue ou une aiguille. Bien entendu, d'autres composants tels qu'une pièce d'ébauche, une ancre, une bascule ou une came sont également des applications envisageables sans sortir du cadre de l'invention.

Enfin, le revêtement peut comporter au moins deux couches, c'est-à-dire fonctionnelle et / ou hybride et / ou mécanique, pour générer au moins une couleur par effet interférentiel afin de décorer selon une couleur prédéterminée le composant horloger.

L'invention a également pour objet une pièce d'horlogerie comportant un mouvement horloger, caractérisée en ce qu'elle comprend un composant horloger tel que présenté plus haut. Typiquement, le composant horloger peut former tout ou partie d'un habillage de la pièce d'horlogerie ou du mouvement de la pièce d'horlogerie.

En outre, selon un premier mode de réalisation, l'invention a pour objet un procédé de fabrication d'un composant horloger comportant un substrat au moins partiellement recouvert par un revêtement, caractérisé en ce que le procédé comporte les étapes suivantes :
a. former le substrat du composant horloger ;
b. déposer, par une méthode MLD, au moins une couche fonctionnelle à base d'au moins un précurseur d'un matériau organique sur le substrat afin d'améliorer la durabilité dudit revêtement.

Enfin, selon un deuxième mode de réalisation, l'invention a pour objet un procédé de fabrication d'un composant horloger comportant un substrat au moins partiellement recouvert par un revêtement, caractérisé en ce que le procédé comporte les étapes suivantes :
a. former le substrat du composant horloger ;
b. déposer, par une méthode hybride MLD/ALD, au moins une couche hybride à base d'au moins un précurseur d'un matériau organique et d'au moins un précurseur d'un matériau inorganique sur le substrat afin d'améliorer la durabilité dudit revêtement.

L'étape b avantageusement selon l'invention permet des dépôts par exemple compris entre quelques ångström (0,1 nm) à 500 nm, c'est-à-dire de faible ou de grande épaisseur, et avec une homogénéité d'épaisseur remarquablement reproductible. Par la nature gazeuse des précurseurs utilisés par la méthode MLD, avantageusement selon l'invention, ladite au moins une couche fonctionnelle ou hybride est déposée possiblement sur toute la surface externe du substrat, y compris dans des évidements borgnes de section faible et de grande profondeur. L'étape b permet de rendre le revêtement obtenu plus souple et plus étanche.

L'étape b permet avantageusement selon l'invention de déposer des couches de ladite au moins une couche fonctionnelle ou hybride de matériaux très variés ce qui permet une adhérence sur une plus grande variété de matériaux pour la surface de dépôt. Ainsi, les molécules de ladite au moins une couche fonctionnelle ou hybride peuvent être sélectionnées par rapport à l'interface prévue (substrat et / ou couche déposée au-dessous et / ou couche déposée au-dessus) pour former des liaisons covalentes comme, par exemple, avec une couche à base d'argent (Ag, couche au-dessous), un vernis ou une laque (couche au-dessus) afin d'améliorer, avantageusement selon l'invention, l'adhérence du revêtement.

De manière complémentaire, les molécules dudit précurseur peuvent être sélectionnées par rapport à d'autres précurseurs injectés pendant le procédé (avant et / ou après) pour former des liaisons covalentes afin d'améliorer, avantageusement selon l'invention, l'adhérence du revêtement, ou à une fonction prévue pour le revêtement pour modifier la tension de surface ou la chimie de surface du revêtement.

L'invention peut également comporter l'une ou plusieurs des caractéristiques optionnelles suivantes, prises seules ou en combinaison.

Ledit au moins un précurseur dudit matériau organique peut comporter une chaîne avec au moins deux atomes de carbone afin d'apporter une flexibilité au revêtement. Bien entendu, plus la chaîne sera longue, plus elle sera flexible. Préférentiellement, le matériau organique comporte entre 4 et 30 atomes de carbone par chaîne et encore plus préférentiellement entre 50 et 10 atomes de carbone par chaîne.

Bien entendu, chaque chaîne peut comporter au moins un hétéroatome tel que du soufre (S), de l'oxygène (O) ou de l'azote (N). En outre, chaque chaîne peut comporter au moins un cycle aromatique et / ou aliphatique. Enfin, chaque chaîne peut être saturée ou non et / ou comporter une structure linéaire ou non (par exemple trois, quatre ou cinq banches permettant d'ajouter des fonctionnalités chimiques).

Ledit au moins un précurseur dudit matériau organique peut comporter au moins un site fonctionnel sur au moins une terminaison. Cette dernière permet ainsi d'interagir avec le substrat ou du côté opposé au substrat.

Selon un premier exemple, ledit au moins un site fonctionnel peut comporter une amine, un thiol, un hydroxyle, un époxyde, un acide carboxylique, un acrylate, un silane ou un organosilane afin d'améliorer l'adhérence du revêtement sur le substrat ou une autre couche par-dessus.

Selon un deuxième exemple, ledit au moins un site fonctionnel peut comporter une polyurée, une glycine, un glucose, un alcane, un alcool, un acide carboxylique, un organosilane, une organosilicone ou un composé perfluoré afin de former une surface externe du revêtement hydrophile, hydrophobe et / ou lipophobe.

Ledit précurseur dudit matériau organique peut être à base de 4-aminophénol, 1,4-butanediol, 1,6-hexanediol, d'éthylène glycol, d'hydroquinone, d'acide benzèndicarboxylique ou d'éthylanoamine.

Le procédé peut comporter en outre l'étape suivante :
c. déposer, par méthode ALD, au moins une couche mécanique à base d'un précurseur d'un matériau inorganique afin d'améliorer la résistance mécanique et / ou la qualité optique dudit revêtement.

On comprend que le procédé peut effectuer une étape b puis une étape c ou inversement. Les méthodes ALD, MLD et hybride MLD/ALD étant compatibles, le substrat n'a pas nécessairement à être changé d'enceinte contrôlée. Les phases d'injections de précurseurs et de purge peuvent donc se succéder dans la même enceinte pour mettre en oeuvre au moins une étape b et au moins une étape c.

Ledit précurseur de ladite couche mécanique peut être un précurseur d'un matériau à base de céramique, c'est-à-dire à base d'un matériau (cristallin et/ou amorphe) à base d'un oxyde, carbure, sulfure ou nitrure.

Le procédé peut comporter plusieurs étapes b et/ou plusieurs étapes c. Préférentiellement, les étapes b et c sont alternées. Toutefois, deux étapes b (identiques ou non) et / ou deux étapes c (identiques ou non) successives (l'une sur l'autre) peuvent être réalisées. Suivant les applications envisagées, les paramètres du procédé sont adaptés pour sélectivement modifier l'épaisseur et le matériau de chaque couche (mécanique, hybride ou fonctionnelle).

### BRÈVE DESCRIPTION DES DESSINS

D'autres particularités et avantages de l'invention ressortiront clairement de la description qui en est faite ci-après, à titre indicatif et nullement limitatif, en référence aux dessins annexés, dans lesquels :
- la figure 1 est une vue schématique d'un exemple de pièce d'horlogerie selon l'invention ;
- la figure 2 est une vue en perspective d'un exemple de composant horloger selon l'invention ;
- la figure 3 est un schéma descriptif d'un exemple de phases d'une étape b du procédé selon un deuxième mode de réalisation de l'invention ;
- la figure 4 est une vue schématique en coupe d'un composant en déformation avec une unique couche mécanique ;
- la figure 5 est une vue schématique en coupe d'un exemple de composant horloger en déformation avec une combinaison de couches fonctionnelle (ou hybride) et mécanique selon l'invention ;
- la figure 6 est une vue d'exemples de revêtements organiques successifs obtenus à l'aide d'étapes b successives du procédé selon un premier mode de réalisation de l'invention selon un cycle répété ;
- la figure 7 est un schéma descriptif d'un autre exemple de matériau de revêtement organique obtenu à l'aide du procédé selon le premier mode de réalisation de l'invention selon un supercycle ;
- la figure 8 est un schéma descriptif de l'exemple de matériau de revêtement hybride de la figure 3 ;
- la figure 9 est un schéma descriptif d'un autre exemple de matériau de revêtement hybride obtenu à l'aide du procédé selon le deuxième mode de réalisation de l'invention selon un supercycle ;
- les figures 10 à 15 sont des vues schématiques en coupe d'exemples de composant horloger selon l'invention.

### DESCRIPTION DÉTAILLÉE D'AU MOINS UN MODE DE RÉALISATION DE

### L'INVENTION

Sur les différentes figures, les éléments identiques ou similaires portent les mêmes références, éventuellement additionnés d'un indice. La description de leur structure et de leur fonction n'est donc pas systématiquement reprise.

Dans tout ce qui suit, les orientations sont les orientations des figures. En particulier, les termes « supérieur », « inférieur », « gauche », « droit », « au-dessus », « en-dessous », « vers l'avant » et « vers l'arrière » s'entendent généralement par rapport au sens de représentation des figures. Le terme « horizontal » s'entend donc comme une direction parallèle à la section principale de la platine du mouvement horloger et le terme « vertical » s'entend comme une direction perpendiculaire à la direction horizontale et parallèle à l'épaisseur de la platine du mouvement horloger.

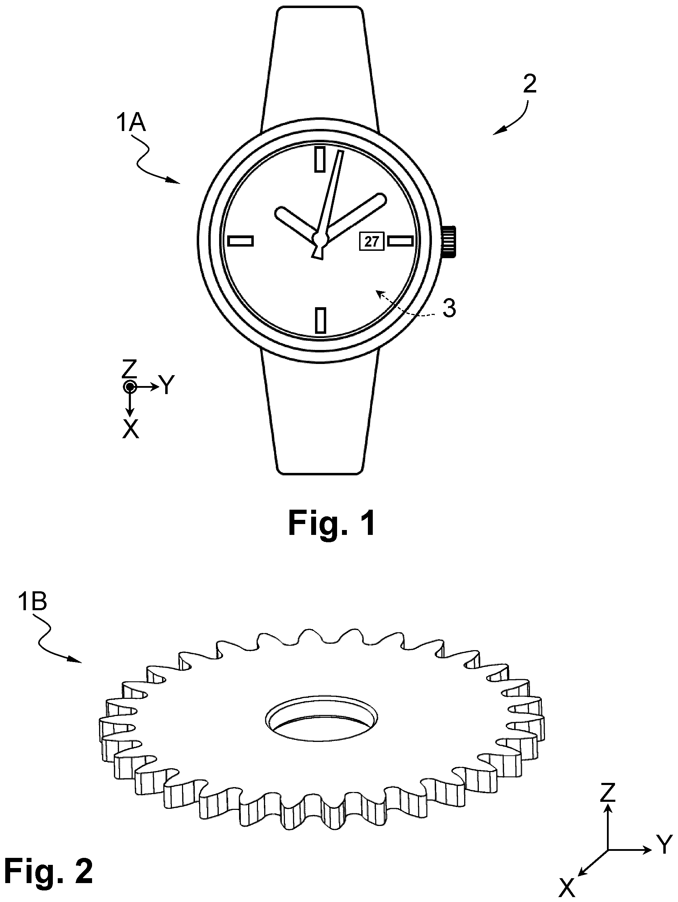

Dans tout ce qui suit, les termes d'orientation s'entendent par rapport au repère orthogonal représenté sur la figure 1 et dans lequel on distingue :
- un axe longitudinal X, horizontal s'étendant de l'arrière vers l'avant ;
- un axe transversal Y, horizontal s'étendant de la gauche vers la droite ; et
- un axe vertical Z, s'étendant du bas vers le haut.

Le terme « horizontal » est défini par rapport au plan XY (direction parallèle à la section principale de la platine du mouvement horloger 3), les termes « plan vertical » sont définis par rapport à une composante horizontale projetée selon l'axe vertical Z (direction perpendiculaire à la direction horizontale et parallèle à l'épaisseur de la platine du mouvement horloger 3).

Par « à base de », on entend un matériau ou alliage constituant au moins 50 % en masse totale ou poids d'un élément donné tel que notamment 51 %, 55 %, 60 %, 65 %, 70 %, 75 %, 80 %, 85 %, 90 %, 95 % ou 100 % en masse totale. Bien entendu, dans le cas d'un matériau ou alliage comportant au moins trois éléments, l'expression « à base d'un premier élément » signifie un matériau ou alliage constitué majoritairement en masse totale ou poids dudit premier élément qui peut être dans ce cas inférieur à 50 % de la masse totale. Dans ce qui suit, sauf indication contraire, tous les pourcentages (%) indiqués sont des pourcentages en masse totale ou poids (en anglais « weight »).

Par « pièce d'horlogerie 2 », on entend tous les types d'instruments de mesure ou de comptage du temps tels que les pendules, les pendulettes, les montres, etc...

Par « mouvement horloger 3 », on entend tous les types de mécanisme capables de compter le temps qu'ils soient alimentés à base d'énergie mécanique (par exemple un barillet) ou électrique (par exemple une batterie).

Par « dépôt de faible épaisseur », on entend une couche mince de matériau déposée sur une surface de réception (cible) dont l'épaisseur est comprise sensiblement entre 1 nm et 100 nm telle qu'une couche 20A ou 20B du revêtement 20 par exemple mise en oeuvre par l'étape b et / ou c du procédé selon l'invention. Le dépôt de faible épaisseur peut ainsi comprendre une épaisseur de matériau déposée égale à 1 nm, 5 nm, 10 nm, 20 nm, 30 nm, 40 nm, 50 nm, 60 nm, 70 nm, 80 nm, 90 nm ou 100 nm.

Inversement, par « dépôt de grande épaisseur », on entend une couche unique ou cumulée (plusieurs dépôts) dont l'épaisseur est supérieure à 100 nm. Le dépôt de grande épaisseur peut ainsi comprendre une épaisseur de matériau déposée égale à 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm ou 1000 nm.

Par « revêtement de bonne adhérence », on entend un revêtement qui résiste aux tests d'adhérence (« test au scotch ») des normes NIHS 96-50 à l'aide d'une traction d'un ruban adhésif préalablement appliqué sur le revêtement (comme, par exemple, avec les produits 3M 600 ou 3M 845 de la société 3M^{®}). De fait, soit l'adhérence est bonne car le revêtement reste intact au test d'adhérence, soit l'adhérence est mauvaise car le revêtement est partiellement ou totalement délaminé (au moins une partie revêtement reste sur le ruban adhésif) lors du test d'adhérence.

L'unité « sccm » est une abréviation anglaise de « Standard Cubic Centimeters per Minute ». Elle est l'unité de travail la plus répandue de débit massique d'un gaz. Cette unité correspond au débit du gaz injecté dans l'enceinte sous vide en cm^{3·}min⁻¹ aux conditions standards de température et de pression.

Par « polymère », on entend tous les matériaux formés à base d'au moins une chaîne polymère, parfois appelée fibre, plus ou moins longue qui peuvent être aussi bien d'origine naturelle que synthétique. Dans le cadre de l'invention, le terme polymère peut donc se rapporter par exemple à un acrylonitrile butadiène styrène (ABS), un polyamide (PA), un polycarbonate (PC), un cyclo-oléfine (CO) ou encore un polyméthacrylate de méthyle (PMMA).

Par « céramique », on entend tous les matériaux sous forme cristalline et/ou amorphe à base d'un oxyde, carbure, sulfure ou nitrure notamment métallique tels que l'oxyde d'aluminium (alumine, Al₂O₃), l'oxyde de silicium (SiOz), le nitrure de silicium (Si₃N₄), le nitrure d'aluminium (AIN) ou le carbure de silicium (SiC).

Par « oxyde », on entend tous les matériaux sous forme cristalline et/ou amorphe à base d'une molécule (MₓO_{y}) comprenant l'élément oxygène (O), tel notamment qu'un oxyde métallique. Un oxyde peut donc comporter de l'oxyde d'aluminium (alumine, Al₂O₃), de l'oxyde de zinc (ZnO), de l'oxyde de titane (TiO₂), de l'oxyde de silicium (SiOz), de l'oxyde de zirconium (zircone, ZrO₂), de l'oxyde de tantale (Ta₂O₅), de l'oxyde de magnésium (MgO), de l'oxyde d'indium-étain (parfois abrégé ITO en anglais, combinaison de In₂O₃ et de SnO₂) et de l'oxyde d'hafnium (HfO₂).

Par « méthode ALD » venant des termes anglais « Atomic Layer Déposition », on entend un procédé de dépôt en couches atomiques permettant donc un dépôt en couche de faible épaisseur et uniforme sur une surface (sa faible épaisseur empêchant toute existence sans surface de dépôt), c'est-à-dire typiquement à ± 1 nm. En effet, plus que la faible valeur de l'épaisseur de dépôt, c'est l'uniformité de l'épaisseur de la (ou des) couche(s) déposée qui est particulièrement déterminante pour le choix de la méthode ALD. La méthode ALD étant très connue, elle ne sera pas d'avantage expliquée ci-dessous.

Par « méthode MLD » venant des termes anglais « Molecular Layer Déposition », on entend un procédé de fabrication en couches moléculaires sur un principe dérivé du dépôt en couches atomiques. La méthode permet de déposer des couches de matériaux organiques ce qui permet une adhérence sur une plus grande variété de matériaux pour la surface de dépôt en comparaison du dépôt en couches atomiques (qui ne permet par ailleurs que des dépôts inorganiques tels que des métaux ou des métalloïdes).

Les dépôts par méthode MLD sont réalisés sous pression réduite voire à pression ambiante (entre 1 mbar et 1 bar) dans une cuve chauffée ou non (entre 20 °C et 500 °C, de préférence inférieure à 120 °C pour éviter la dégradation des molécules) à l'aide de précurseurs gazeux. Ces précurseurs gazeux peuvent être introduits à l'aide d'un gaz porteur tel qu'un gaz inerte (par exemple argon (Ar) ou azote (N₂)) par des séquences alternées afin qu'ils s'adsorbent à la surface de réception (cible du dépôt par méthode MLD).

Plus précisément, la méthode MLD consiste à exposer une surface de réception successivement à différents précurseurs chimiques afin d'obtenir des couches de faible épaisseur de composés organiques. Elle est basée sur des réactions de surface auto-saturées qui ont lieu séquentiellement permettant une croissance contrôlée. En général, un cycle d'une méthode MLD comprend au moins deux injections de précurseurs, ces injections étant séparées par une étape de purge servant à éliminer le précurseur et les produits de réaction avant l'introduction de l'autre précurseur. Avantageusement, la technologie MLD permet de déposer des couches sur une surface de réception présentant un très fort rapport d'aspect, car la réaction se déroule sur une monocouche de gaz précurseurs adsorbés directement à la surface de réception.

Par « méthode hybride MLD/ALD », on entend un procédé de fabrication combinant les méthodes ALD et MLD, c'est-à-dire combinant des couches atomiques et moléculaires. Il permet par exemple de déposer successivement des métaux (ou des métalloïdes) et des matériaux organiques (molécules organiques et/ou organométalliques), c'est-à-dire aussi bien organiques qu'inorganiques, ce qui permet une adhérence sur une plus grande variété de matériaux pour la surface de dépôt en comparaison du dépôt en couches atomiques (qui ne permet par ailleurs que des dépôts inorganiques) mais également entre les dépôts successifs voire une fonctionnalisation plus simple de la dernière couche. Bien entendu, la méthode hybride MLD/ALD peut former davantage que deux couches différentes de matériaux pour former un « supercycle ».

Plus précisément, la méthode hybride MLD/ALD consiste à exposer une surface de réception successivement à des premiers précurseurs chimiques afin d'obtenir des couches de faible épaisseur de composés organiques et à des deuxièmes précurseurs chimiques afin d'obtenir des couches de faible épaisseur d'atomes choisis, ou inversement. Elle est basée sur des réactions de surface auto-saturées qui ont lieu séquentiellement permettant une croissance contrôlée. En général, un cycle d'une méthode hybride MLD/ALD comprend au moins deux injections de deux précurseurs différents, ces injections étant séparées par une étape de purge servant à éliminer le précurseur et les produits de réaction superflus avant l'introduction de l'autre précurseur. Avantageusement, la méthode hybride MLD/ALD permet de déposer des couches sur une surface de réception présentant une très haute technicité.

Le composant 1 a été développé pour s'appliquer au domaine horloger. Ainsi, le composant horloger 1 peut former tout ou partie d'un habillage horloger 1A (exemple illustré à la figure 1) comme tout ou partie d'un cadran ou d'un réhaut, d'un affichage tel qu'une aiguille ou un disque, d'une boîte, d'un bracelet, d'une glace ou d'un organe de commande tel qu'une couronne ou un bouton-poussoir. Le composant horloger 1 peut également former tout ou partie d'un mouvement horloger 3 comme tout ou partie d'un dispositif d'échappement tel qu'un mécanisme à ancre suisse, d'un résonateur tel qu'un mécanisme balancier - spiral, d'une source d'énergie tel qu'un barillet, un système de remontage automatique ou une batterie, d'un rouage tel qu'un mobile ou une roue dentée 1B (exemple illustré à la figure 2), d'un ressort, d'une vis, d'un pont ou d'une platine.

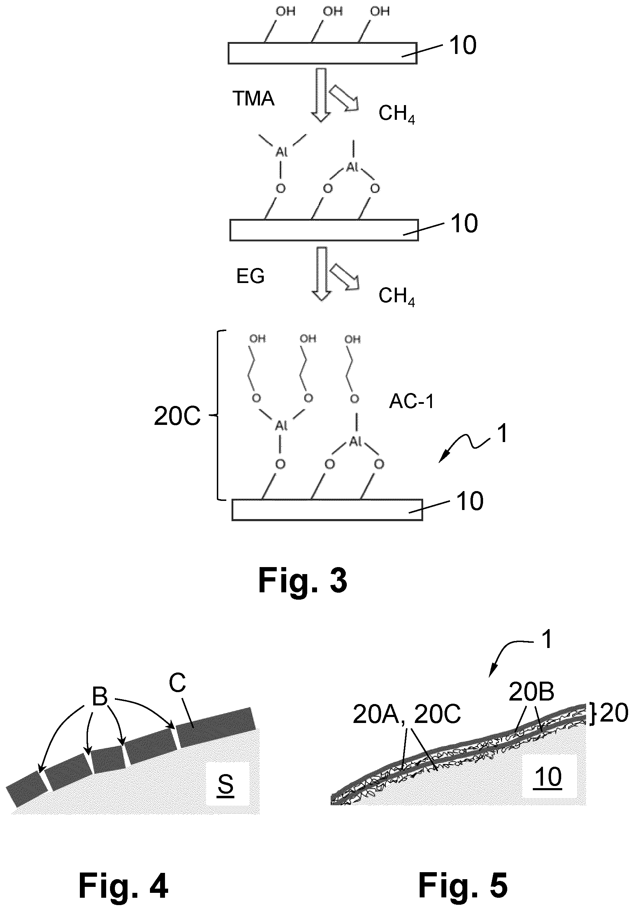

Selon l'invention, le composant horloger 1 est formé d'un substrat 10 qui est au moins partiellement recouvert par un revêtement 20. Comme visible à la figure 4, il est connu de déposer une couche C de grande épaisseur d'alumine sur une substrat S par méthode ALD. Toutefois, il a été remarqué que cette couche C déposée par méthode ALD présentent des inconvénients. Ainsi, l'adhérence de la couche C d'alumine sur un substrat S métallique ne permet de réussir au « test du scotch », le phénomène étant d'autant plus marqué pour des métaux nobles tels que l'argent ou l'or. En outre, une telle couche est très rigide ce qui la rend très cassante au point d'être inapplicables sur des substrat S utilisé en déformation (cf. figure 4, bris B de la couche C). Une telle couche C déposée par méthode ALD ne permet pas au final de garantir une protection durable du substrat S au cours du temps.

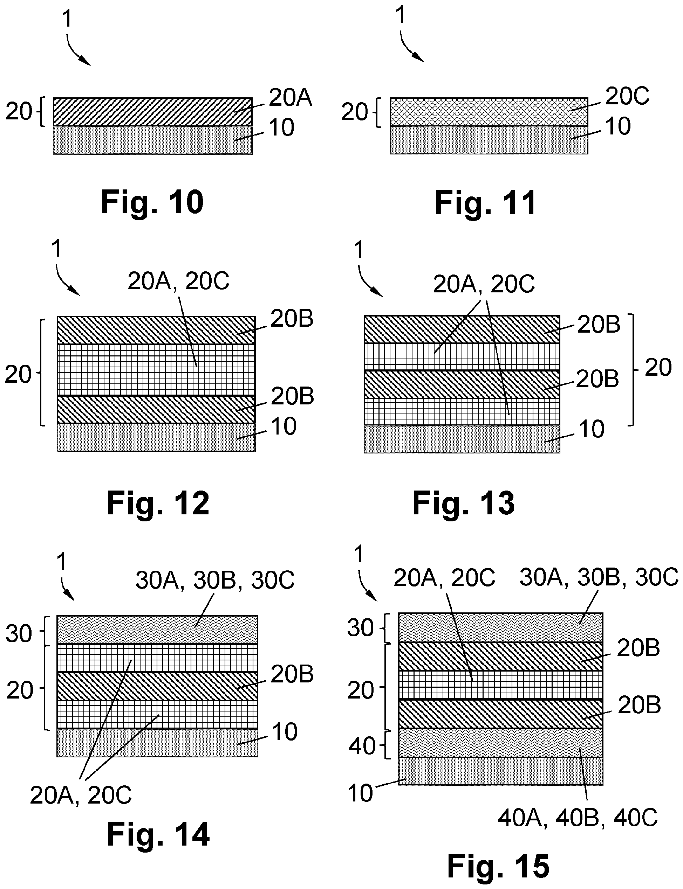

Ainsi, avantageusement, le revêtement 20 selon l'invention comporte au moins une couche 20A fonctionnelle, déposée par méthode MLD, à base d'un matériau organique afin d'améliorer la durabilité du revêtement 20 selon un premier mode de réalisation visible dans l'exemple de la figure 10. Alternativement, le revêtement 20 selon l'invention comporte au moins une couche 20C hybride, déposée par méthode hybride MLD/ALD, à base d'un matériau organique et d'un matériau inorganique afin d'améliorer la durabilité du revêtement 20 selon un deuxième mode de réalisation visible dans l'exemple de la figure 11.

Avantageusement selon l'invention, ladite au moins une couche 20A fonctionnelle ou 20C hybride à base dudit matériau organique apporte une flexibilité au revêtement 20 qui évite l'accumulation de contraintes internes même en dépôts cumulés de grande épaisseur, c'est-à-dire typiquement supérieure à 100 nm, ce qui garantit une haute durabilité du revêtement 20.

En effet, les risques de délamination (« test du scotch » positif) et de bris notamment à cause des contraintes internes accumulées dans le revêtement sont limitées voire éliminées par l'invention même sur un composant horloger 1 utilisé en déformation. Par la nature gazeuse des précurseurs utilisés par méthode MLD ou méthode hybride MLD/ALD, avantageusement selon l'invention, le revêtement 20 va être homogène sur possiblement toute la surface externe du substrat 10, y compris dans des évidements borgnes à l'accessibilité difficile. On comprend donc que le revêtement 20 selon l'invention permet notamment une protection efficace contre le ternissement des matériaux du substrat 10 tels que l'argent ou plus généralement offre une barrière mécanique et chimique efficace.

En outre, les molécules de ladite au moins une couche 20A fonctionnelle ou 20C hybride déposées à l'échelle nanométrique peuvent également contribuer à générer des couleurs par phénomène interférentiel. Enfin, les molécules de ladite au moins une couche 20A fonctionnelle ou 20C hybride peuvent être sélectionnées par rapport à l'interface prévue (substrat 10 et/ou couche 20A, 20B, 20C déposée avant et/ou couche 20A, 20B, 20C déposée par-dessus) pour former des liaisons covalentes comme, par exemple, avec une couche à base d'argent (Ag), un vernis ou une laque afin d'améliorer, avantageusement selon l'invention, l'adhérence du revêtement 20.

Par exemple, pour l'adhérence des vernis et laques acryliques sur une couche 20B mécanique, il est possible d'utiliser les molécules suivantes :
TRIAP (N-(3-triméthoxysilylpropyle) diéthylènetriamine ; CAS : 35141-30-1)
MEA (2-aminoéthanol ; CAS 141-43-5)
TMSAPMA (3-(triméthoxysilyle)propyle méthacrylate ; CAS : 2530-85-0)
HEMA (hydroxyéthylméthacrylate ; CAS : 868-77-9)
MPTS ((3-mercaptopropyle)triméthoxysilane ; CAS : 4420-74-0)
GLYMO (3-glycidyloxypropyle)triméthoxysilane ; CAS : 2530-83-8)
(3-acryloxypropyl)triméthoxysilane, 96% (CAS : 4369-14-6).

Enfin, le composant horloger 1 selon l'invention apporte une nette amélioration en termes d'étanchéité par rapport à une couche C d'alumine de l'art antérieur. La présence de fissures (ou bris B) dans un dépôt et de manque d'étanchéité peut se mesurer avec le taux de transmission de la vapeur d'eau (parfois abrégé « WVTR » venant des termes « Water Vapour Transmission Rate »). Plus ce taux est élevé, plus le dépôt présente des failles, bris B ou porosités dans lesquelles la vapeur d'eau peut s'infiltrer.

Le taux de transmission de la vapeur d'eau d'une couche C d'alumine par méthode ALD se situe entre 10⁻³ et 10⁻⁴ g·m⁻²·j⁻¹ alors qu'un dépôt de ladite au moins une couche 20A fonctionnelle ou 20C hybride à base d'un matériau organique par méthode MLD ou méthode hybride MLD/ALD selon l'invention a permis d'obtenir un taux de transmission de la vapeur d'eau compris entre 10⁻⁵ à 10⁻⁶ g·m⁻²·j⁻¹. On comprend donc que le composant horloger 1 selon l'invention pour une application statique apporte déjà une nette amélioration en termes d'étanchéité.

L'avantage du composant horloger 1 selon l'invention est encore plus marqué pour une application avec déformations tel qu'un ressort, un ressort-spiral, un sautoir, un cliquet ou un levier. En effet, après travail en déformation (flexion, torsion, compression, etc.), la couche C d'alumine déposée par méthode ALD étant très rigide, le taux de transmission de la vapeur d'eau augmente entre 10⁻² et 10⁻³ g·m⁻²·j⁻¹ . De manière avantageuse, dans une telle situation, un dépôt de ladite au moins une couche 20A fonctionnelle ou 20C hybride à base d'un matériau organique par méthode MLD ou méthode hybride MLD/ALD selon l'invention a permis de maintenir un taux de transmission de la vapeur d'eau sensiblement stable, c'est-à-dire sensiblement compris entre 10⁻⁵ à 10⁻⁶ g·m⁻²·j⁻¹. Cela démontre l'avantage du revêtement 20 selon l'invention qui reste plus stable et plus étanche lors de sollicitations mécaniques.

Ledit matériau organique de ladite au moins une couche 20A fonctionnelle ou 20C hybride doit s'entendre comme formé d'au moins une molécule organique et/ou organométallique. Un tel matériau organique peut comporter une chaîne avec au moins deux atomes de carbone afin d'apporter une flexibilité au revêtement 20. Bien entendu, plus la chaîne sera longue, plus elle sera flexible. Préférentiellement, le matériau organique comporte entre 4 et 30 atomes de carbone par chaîne et encore plus préférentiellement entre 5 et 100 atomes de carbone par chaîne. Bien entendu, chaque chaîne peut comporter au moins un hétéroatome tel que du soufre (S), de l'oxygène (O) ou de l'azote (N). En outre, chaque chaîne peut comporter au moins un cycle aromatique et / ou aliphatique. Enfin, chaque chaîne peut être saturée ou non et / ou comporter une structure linéaire ou non (par exemple trois, quatre ou cinq banches permettant d'ajouter des fonctionnalités chimiques).

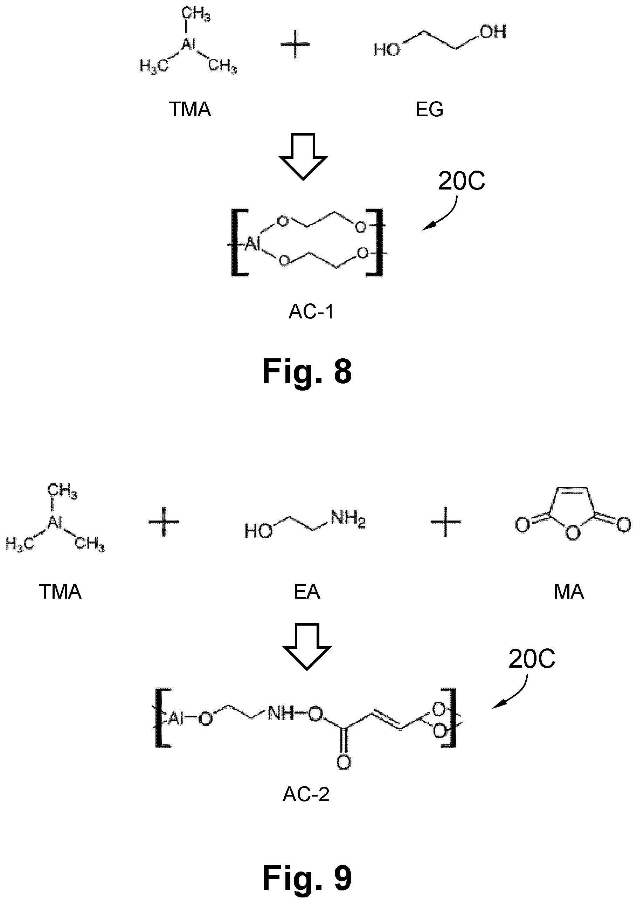

Ledit matériau hybride peut, par exemple, être à base de alucone (AC, comme visible aux figures 3 et 8), titanicone, zincone, hafnicone, mangancone, vanadicone.

Le matériau organique de ladite au moins une couche 20A fonctionnelle ou 20C hybride peut comporter au moins un site fonctionnel sur au moins une terminaison afin d'apporter une fonction d'adhérence et / ou de compatibilité avec un matériau au-dessus et / ou au-dessous, et / ou de modification de tension de surface et / ou de modification de la chimie de surface.

Selon un exemple, ledit au moins un site fonctionnel peut comporter une polyurée, une glycine, un glucose, un alcane, un alcool, un acide carboxylique, un organosilane, une organosilicone ou un composé perfluoré afin de former un revêtement hydrophile, hydrophobe et / ou lipophobe. Cette spécialisation du revêtement peut être par exemple utilisée comme épilame ou pour augmenter les qualités tribologiques.

Avantageusement selon l'invention, le revêtement 20 peut comporter en outre au moins une couche 20B mécanique, déposée par méthode ALD, à base d'un matériau inorganique afin d'améliorer la résistance mécanique et / ou la qualité optique dudit revêtement. On comprend que ladite au moins une couche 20A fonctionnelle ou 20C hybride va éventuellement se déformer pour limiter voire éviter toute détérioration de ladite au moins une couche 20B mécanique tout en maintenant l'encapsulation du substrat 10 (étanchéité, adhérence, etc.) et éventuellement en améliorant l'adhérence que possède ladite au moins une couche 20B mécanique par rapport au substrat 10, c'est-à-dire si ladite au moins une couche 20B mécanique avait été déposée directement sur le substrat 10.

Ladite au moins une couche 20B mécanique peut être à base de céramique, c'est-à-dire à base d'un matériau (cristallin et/ou amorphe) à base d'un oxyde et / ou carbure et / ou sulfure et / ou nitrure tels que l'oxyde d'aluminium (alumine, Al₂O₃), l'oxyde de silicium (SiO₂), le nitrure de silicium (Si₃N₄), le nitrure d'aluminium (AIN) ou le carbure de silicium (SiC).

Dans les exemples illustrés aux figures 5 et 12 à 15, le revêtement 20 comporte plusieurs couches 20A fonctionnelles ou 20C hybride et / ou plusieurs couches 20B mécaniques. Préférentiellement, ladite au moins une couche 20A fonctionnelle ou 20C hybride et ladite au moins une couche 20B mécanique sont alternativement déposées. Toutefois, deux couches 20B mécaniques (identiques ou non) et / ou deux couches 20A fonctionnelles ou 20C hybride (identiques ou non) successives (l'une sur l'autre) peuvent être déposées. Suivant les applications envisagées, les épaisseurs de chaque couche (20B mécanique, 20C hybride ou 20A fonctionnelle) peuvent être sélectivement choisies.

En outre, le composant horloger 1 peut comporter une couche externe 30 et / ou une couche interne 40 en plus du revêtement 20. La couche externe 30 peut être sélectionnées pour former des liaisons covalentes, par exemple, avec un vernis ou une laque afin d'améliorer, avantageusement selon l'invention, l'adhérence du revêtement 20. La couche 30 peut comporter une couche 30A fonctionnelle, une couche 30B mécanique ou une couche 30C hybride. La couche interne 40 peut être sélectionnées pour former des liaisons covalentes, par exemple, avec un substrat 10 à base d'argent (Ag) afin d'améliorer, avantageusement selon l'invention, l'adhérence du revêtement 20. La couche 40 peut comporter une couche 40A fonctionnelle, une couche 40B mécanique ou une couche 40C hybride.

Ainsi, selon un premier mode de réalisation, le procédé de fabrication selon l'invention comporte les étapes suivantes :
a. former le substrat 10 du composant horloger 1 ;
b. déposer, par une méthode MLD, au moins une couche 20A fonctionnelle à base d'au moins un précurseur d'un matériau organique sur le substrat 10 afin d'améliorer la durabilité dudit revêtement 20.

Selon un deuxième mode de réalisation, le procédé de fabrication selon l'invention comporte les étapes suivantes :
a. former le substrat 10 du composant horloger 1 ;
b. déposer, par une méthode hybride MLD/ALD, au moins une couche 20C hybride à base d'au moins un précurseur d'un matériau organique et d'au moins un précurseur d'un matériau inorganique sur le substrat 10 afin d'améliorer la durabilité dudit revêtement 20.

L'étape a peut être réalisée à partir d'une fabrication habituelle d'un composant horloger 1 tel qu'un cadran, une boîte de montre, un ressort-spiral ou roue dentée 1B. Avantageusement selon l'invention, le matériau du substrat 10 peut ainsi être indifféremment à base de polymère tel qu'un polyamide (PA), qu'un polycarbonate (PC), de métal tel que à base d'argent (Ag), de nickel (Ni, NiZn, NiAu), de niobium (NbZr, NbTi) ou d'or (Au), ou d'un métalloïde tel que du silicium (Si) ou du germanium (Ge).

L'étape b avantageusement selon l'invention permet le dépôt de ladite au moins une couche 20A fonctionnelle ou 20C hybride d'une épaisseur par exemple comprise entre quelques ångströms (0,1 nm) et 500 nm, c'est-à-dire de faible ou de grande épaisseur, et avec une homogénéité d'épaisseur remarquablement reproductible. Par la nature gazeuse des précurseurs utilisés par la méthode MLD ou méthode hybride MLD/ALD, avantageusement selon l'invention, ladite au moins une couche 20A fonctionnelle ou 20C hybride est déposée possiblement sur toute la surface externe du substrat 10, y compris dans des évidements borgnes de section faible et de grande profondeur. L'étape b permet de rendre le revêtement 20 obtenu plus souple et plus étanche.

L'étape b permet avantageusement selon l'invention de déposer des couches de ladite au moins une couche 20A fonctionnelle ou 20C hybride de matériaux très variés ce qui permet une adhérence sur une plus grande variété de matériaux pour la surface de dépôt (substrat 10, ladite au moins une couche 20A fonctionnelle, ladite au moins une couche 20C hybride ou ladite au moins une couche 20B mécanique). Ainsi, les molécules de ladite au moins une couche 20A fonctionnelle ou 20C hybride peuvent être sélectionnées par rapport à l'interface prévue (substrat 10 et / ou couche 20A, 20B, 20C déposée avant et / ou couche 20A, 20B, 20C déposée par-dessus) pour former des liaisons covalentes comme, par exemple, avec un substrat 10 à base d'argent (Ag), un vernis ou une laque afin d'améliorer, avantageusement selon l'invention, l'adhérence du revêtement 20.

De manière complémentaire, les molécules dudit précurseur peuvent être sélectionnées par rapport à d'autres précurseurs injectés pendant le procédé (avant et / ou après) pour former des liaisons covalentes afin d'améliorer, avantageusement selon l'invention, l'adhérence du revêtement 20 (couche interne 40), ou à une fonction (couche externe 30) prévue pour le revêtement 20 pour modifier la tension de surface ou la chimie de surface du revêtement 20.

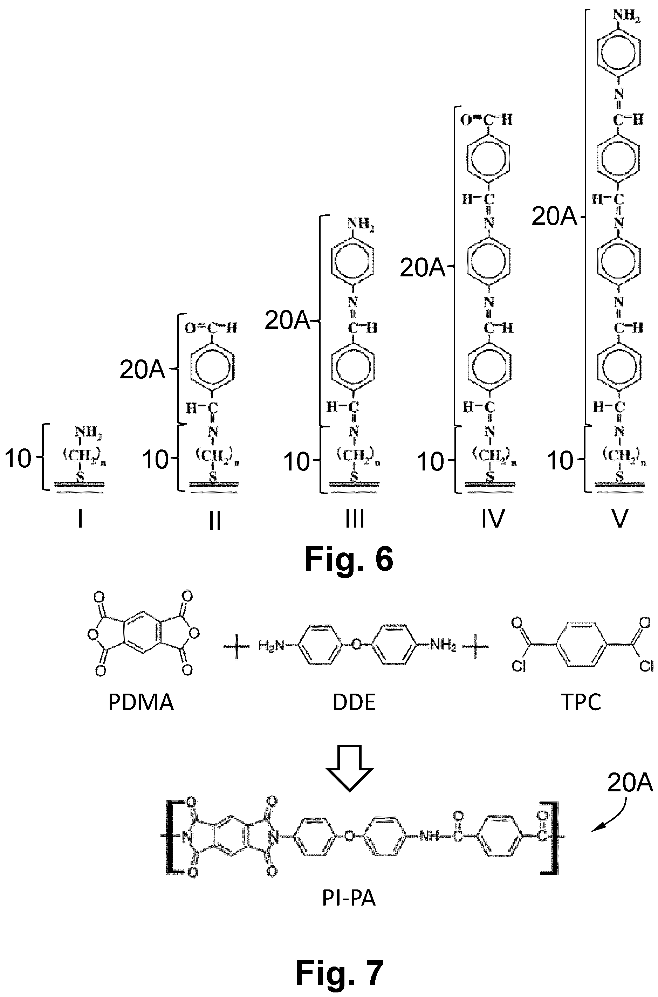

Dans l'exemple illustré à la figure 6 formant un cycle répété, un dépôt par méthode MLD peut être réalisé en utilisant la séquence suivante qui peut être répétée (avec les mêmes précurseurs ou non) suivant l'épaisseur (par exemple de quelques Angströms à 500 nm) souhaitée du dépôt (bien entendu, si une répétition est effectuée, il n'y a plus besoin de phase d'initialisation) :
- initialisation (figure 6-I) : paramétrage de l'enceinte (pression, température, purge avec un gaz inerte, etc.) afin notamment d'avoir une atmosphère contrôlée non réactive avec les produits qui seront utilisés lors du procédé ;
- première injection : Introduction d'un premier précurseur sous forme de gaz de type organique (par exemple acide téréphtalique (TPA, C₆H₄(CO₂H)₂)) pendant 0,1 à 60 s (seconde) à des débits allant de 1 à 1000 sccm. Ce premier précurseur va s'absorber sur la surface et adhérer en formant des liaisons avec des groupements résiduels (par exemple : amine ou hydroxyle).
- première purge (figure 6-II) : Une fois que la surface est saturée en premier précurseur, il faut purger l'enceinte avec un gaz inerte (par exemple argon (Ar) ou azote (N₂)) pendant 1 à 360 s ;
- deuxième injection : Introduction du deuxième précurseur sous forme gazeux de type organique (par exemple paraphénylènediamine (PPDA, C₆H₄(NH₂)₂)) pendant 0,1 à 60 s à des débits allant de 1 à 1000 sccm. Ce deuxième précurseur va s'absorber sur la surface et adhérer en formant des liaisons avec les sites du premier précurseur ;
- deuxième purge (figure 6-III) : Une fois que la surface est saturée en deuxième précurseur, il faut purger l'enceinte avec un gaz inerte (par exemple argon (Ar) ou azote (N₂)) pendant 1 à 360 s.
- troisième injection : Introduction d'un troisième précurseur sous forme de gaz de type organique (par exemple acide téréphtalique (TPA, C₆H₄(CO₂H)₂)) pendant 0,1 à 60 s (seconde) à des débits allant de 1 à 1000 sccm. Ce troisième précurseur va s'absorber sur la surface et adhérer en formant des liaisons avec les sites du deuxième précurseur.
- troisième purge (figure 6-IV) : Une fois que la surface est saturée en troisième précurseur, il faut purger l'enceinte avec un gaz inerte (par exemple argon (Ar) ou azote (N₂)) pendant 1 à 360 s ;
- quatrième injection : Introduction d'un quatrième précurseur sous forme de gaz de type organique (par exemple paraphénylènediamine (PPDA, C₆H₄(NH₂)₂)) pendant 0,1 à 60 s (seconde) à des débits allant de 1 à 1000 sccm. Ce quatrième précurseur va s'absorber sur la surface et adhérer en formant des liaisons avec les sites du troisième précurseur.
- quatrième purge (figure 6-V) : Une fois que la surface est saturée en quatrième précurseur, il faut purger l'enceinte avec un gaz inerte (par exemple argon (Ar) ou azote (N₂)) pendant 1 à 360 s.

Ce premier exemple de la figure 6 permet d'obtenir un revêtement 20 par une couche 20A fonctionnelle purement organique à base de polyazométhine.

Dans l'exemple illustré à la figure 7 formant un supercycle, un dépôt par méthode MLD peut être réalisé en utilisant la séquence suivante qui peut être répétée (avec les mêmes précurseurs ou non) suivant l'épaisseur (par exemple de quelques Angströms à 500 nm) souhaitée du dépôt (bien entendu, si une répétition est effectuée, il n'y a plus besoin de phase d'initialisation) :
- initialisation : paramétrage de l'enceinte (pression, température, purge avec un gaz inerte, etc.) afin notamment d'avoir une atmosphère contrôlée non réactive avec les produits qui seront utilisés lors du procédé ;
- première injection : Introduction d'un premier précurseur sous forme de gaz de type organique (par exemple dianhydride pyromellitique (PDMA, C₆H₂(C₂O₃)₂)) pendant 0,1 à 60 s (seconde) à des débits allant de 1 à 1000 sccm. Ce premier précurseur va s'absorber sur la surface et adhérer en formant des liaisons avec des groupements résiduels (par exemple : amine ou hydroxyle).
- première purge : Une fois que la surface est saturée en premier précurseur, il faut purger l'enceinte avec un gaz inerte (par exemple argon (Ar) ou azote (N₂)) pendant 1 à 360 s ;
- deuxième injection : Introduction du deuxième précurseur sous forme gazeux de type organique (par exemple 4,4'-diaminodiphényléther (DDE, C₁₂H₁₂N₂O)) pendant 0,1 à 60 s à des débits allant de 1 à 1000 sccm. Ce deuxième précurseur va s'absorber sur la surface et adhérer en formant des liaisons avec les sites du premier précurseur ;
- deuxième purge : Une fois que la surface est saturée en deuxième précurseur, il faut purger l'enceinte avec un gaz inerte (par exemple argon (Ar) ou azote (N₂)) pendant 1 à 360 s.
- troisième injection : Introduction d'un troisième précurseur sous forme de gaz de type organique (par exemple chlorure de téréphthaloyle (TPC, C₈H₄Cl₂O₂)) pendant 0,1 à 60 s (seconde) à des débits allant de 1 à 1000 sccm. Ce troisième précurseur va s'absorber sur la surface et adhérer en formant des liaisons avec les sites du deuxième précurseur.
- troisième purge : Une fois que la surface est saturée en troisième précurseur, il faut purger l'enceinte avec un gaz inerte (par exemple argon (Ar) ou azote (N₂)) pendant 1 à 360 s ;

Ce deuxième exemple de la figure 7 permet d'obtenir un revêtement 20 par une couche 20A fonctionnelle purement organique à base de polyimide (PI) et de polyamide (PA).

Dans l'exemple illustré aux figures 3 et 8, un dépôt par méthode hybride MLD/ALD peut être réalisé en utilisant la séquence suivante qui peut être répétée (avec les mêmes précurseurs ou non) suivant l'épaisseur (par exemple de quelques Angströms à 500 nm) souhaitée du dépôt (bien entendu, si une répétition est effectuée, il n'y a plus besoin de phase d'initialisation) :
- initialisation : paramétrage de l'enceinte (pression, température, purge avec un gaz inerte, etc.) afin notamment d'avoir une atmosphère contrôlée non réactive avec les produits qui seront utilisés lors du procédé ;
- première injection : Introduction d'un premier précurseur sous forme de gaz de type métallique (par exemple triméthylaluminium (TMA, Al₂(CH₃)₆)) pendant 0,1 à 60 s (seconde) à des débits allant de 1 à 1000 sccm. Ce premier précurseur va s'absorber sur la surface et adhérer en formant des liaisons métalliques avec des groupements résiduels (par exemple : amine ou hydroxyle).
- première purge : Une fois que la surface est saturée en premier précurseur, il faut purger l'enceinte avec un gaz inerte (par exemple argon (Ar) ou azote (N₂)) pendant 1 à 360 s ;
- deuxième injection : Introduction du deuxième précurseur sous forme gazeux de type organique (par exemple éthylène glycol (EG, C₂H₆O)) pendant 0,1 à 60 s à des débits allant de 1 à 1000 sccm. Ce deuxième précurseur va s'absorber sur la surface et adhérer en formant des liaisons avec les sites métalliques du premier précurseur ;
- deuxième purge : Une fois que la surface est saturée en deuxième précurseur, il faut purger l'enceinte avec un gaz inerte (par exemple argon (Ar) ou azote (N₂)) pendant 1 à 360 s.

Ce troisième exemple permet d'obtenir un revêtement 20 à base d'alucone (AC-1) comme visible aux figures 3 et 8.

Dans l'exemple illustré à la figure 9 formant un supercycle, un dépôt par méthode hybride MLD/ALD peut être réalisé en utilisant la séquence suivante qui peut être répétée (avec les mêmes précurseurs ou non) suivant l'épaisseur (par exemple de quelques Angströms à 500 nm) souhaitée du dépôt (bien entendu, si une répétition est effectuée, il n'y a plus besoin de phase d'initialisation) :
- initialisation : paramétrage de l'enceinte (pression, température, purge avec un gaz inerte, etc.) afin notamment d'avoir une atmosphère contrôlée non réactive avec les produits qui seront utilisés lors du procédé ;
- première injection : Introduction d'un premier précurseur sous forme de gaz de type métallique (par exemple triméthylaluminium (TMA, Al₂(CH₃)₆)) pendant 0,1 à 60 s (seconde) à des débits allant de 1 à 1000 sccm. Ce premier précurseur va s'absorber sur la surface et adhérer en formant des liaisons métalliques avec des groupements résiduels (par exemple : amine ou hydroxyle).
- première purge : Une fois que la surface est saturée en premier précurseur, il faut purger l'enceinte avec un gaz inerte (par exemple argon (Ar) ou azote (N₂)) pendant 1 à 360 s ;
- deuxième injection : Introduction du deuxième précurseur sous forme gazeux de type organique (par exemple éthanolamine (EA, C₂H₇NO)) pendant 0,1 à 60 s à des débits allant de 1 à 1000 sccm. Ce deuxième précurseur va s'absorber sur la surface et adhérer en formant des liaisons avec les sites métalliques du premier précurseur ;
- deuxième purge : Une fois que la surface est saturée en deuxième précurseur, il faut purger l'enceinte avec un gaz inerte (par exemple argon (Ar) ou azote (N₂)) pendant 1 à 360 s.
- troisième injection : Introduction du deuxième précurseur sous forme gazeux de type organique (par exemple anhydre maléique (MA, C₂H₂(CO)₂O)) pendant 0,1 à 60 s à des débits allant de 1 à 1000 sccm. Ce troisième précurseur va s'absorber sur la surface et adhérer en formant des liaisons avec le deuxième précurseur ;
- troisième purge : Une fois que la surface est saturée en troisième précurseur, il faut purger l'enceinte avec un gaz inerte (par exemple argon (Ar) ou azote (N₂)) pendant 1 à 360 s.

Ce quatrième exemple permet d'obtenir un revêtement 20 à base d'alucone (AC-2) comme visible à la figure 9 selon une chaîne plus longue que le troisième exemple (AC-1) des figures 3 et 8.

Selon une variante, avant la première injection, la surface de réception (substrat 10 et/ ou couche 20A, 20B, 20C déposée) peut également être préalablement traitée avec des promoteurs capables de se greffer entre la surface de réception et le dépôt par méthode MLD ou par méthode hybride MLD/ALD pour conférer un meilleure adhérence via des liaisons covalentes. Les promoteurs peuvent, par exemple, être à base d'éthylène glycol (EG), de paraphénylènediamine (PPD), de polyimide (PI) ou de polyazométhine (PAM).

Chaque précurseur dudit matériau organique peut comporter une chaîne avec au moins deux atomes de carbone afin d'apporter une flexibilité au revêtement, diminuer le stress interne ou encore favoriser une orientation cristalline. Bien entendu, plus la chaîne sera longue, plus elle sera flexible. Préférentiellement, le matériau organique comporte entre 4 et 30 atomes de carbone par chaîne et encore plus préférentiellement entre 5 et 10 atomes de carbone par chaîne. La chaîne carbonée de ladite au moins une couche 20A fonctionnelle ou 20C hybride peut également contenir des cycles aromatiques ou des doubles liaisons carbone-carbone afin de diminuer la flexibilité.

Bien entendu, chaque chaîne peut comporter au moins un hétéroatome tel que du soufre (S), de l'oxygène (O) ou de l'azote (N). En outre, chaque chaîne peut comporter au moins un cycle aromatique et / ou aliphatique. Enfin, chaque chaîne peut être saturée ou non et / ou comporter une structure linéaire ou non (par exemple trois, quatre ou cinq banches permettant d'ajouter des fonctionnalités chimiques).

Ledit au moins un précurseur dudit matériau organique peut comporter au moins un site fonctionnel sur au moins une terminaison. Cette dernière permet ainsi d'interagir avec le substrat 10 ou du côté opposé au substrat 10. Ainsi, les sites fonctionnels peuvent avoir différentes fonctions selon la terminaison choisie. Certaines terminaisons peuvent améliorer l'adsorption chimique avec les métaux, les laques, les vernis ou les oxydes. Le précurseur peut être homo ou hétérofonctionnel, bipodale ou tripodale. Si le précurseur n'a qu'un seul site actif réactionnel, cela permet d'améliorer son orientation préférentielle. Les thiols et les amines forment de fortes liaisons avec les métaux précieux tels que l'or et l'argent et les organosilanes forment de fortes liaisons avec les oxydes métalliques.

Selon un premier exemple, ledit au moins un site fonctionnel peut comporter une amine, un thiol, une amine, un acrylate, un silane ou un organosilane afin d'améliorer l'adhérence du revêtement 20 sur le substrat 10 ou une autre couche 20A, 20B par-dessus et / ou dessous.

Selon un deuxième exemple, ledit au moins un site fonctionnel peut comporter une polyurée, une glycine, un glucose, un alcane, un alcool, un acide carboxylique, un organosilane, une organosilicone ou un composé perfluoré afin de former une surface externe du revêtement 20 hydrophile, hydrophobe et / ou lipophobe.

Ledit précurseur dudit matériau organique peut être à base de 4-aminophénol (AP), 1,4-butanediol (BDO), 1,6-hexanediol (HDO), d'éthylène glycol (EG), d'hydroquinone (HQ), d'acide benzène-1,4-dicarboxylique (BDC) ou d'éthylanoamine (EA).

Il est aussi possible de terminer la séquence d'injection en utilisant un précurseur organique présentant au moins une terminaison compatible avec un précurseur de l'étape c et des propriétés physico-chimiques intéressantes selon les spécificités du composant horloger 1. Le dépôt de ce précurseur permet une bonne adhérence avec ladite au moins une couche 20B mécanique et un caractère hydrophile, hydrophobe ou encore faire office d'épilame selon les exemples de molécules ci-dessus. Ces structures peuvent aussi améliorer les propriétés tribologiques de surface. Notamment en diminuant le coefficient d'abrasivité pour réduire l'usure et augmenter la lubrification.

Les organosilanes forment de fortes liaisons avec les oxydes métalliques, les chaînes aliphatiques, les chaînes polaires et les chaînes fluorées confèrent respectivement des propriétés hydrophobes, hydrophiles et épilame. Ainsi les propriétés physico-chimiques sont fortement améliorées.

Le procédé peut donc comporter en outre l'étape suivante :
c. déposer, par méthode ALD, au moins une couche mécanique à base d'un précurseur d'un matériau inorganique afin d'améliorer la résistance mécanique et / ou la qualité optique dudit revêtement.

On comprend que le procédé peut effectuer une étape b puis une étape c ou inversement. Les méthodes ALD et MLD étant compatibles, le substrat n'a pas nécessairement à être changé d'enceinte contrôlée. Les phases d'injections de précurseurs et de purge peuvent donc se succéder dans la même enceinte pour mettre en oeuvre au moins une étape b et au moins une étape c.

Ledit précurseur de ladite couche mécanique peut être à base de céramique, c'est-à-dire à base d'un matériau (cristallin et/ou amorphe) à base d'un oxyde, carbure, sulfure ou nitrure.

Le procédé peut comporter plusieurs étapes b et/ou plusieurs étapes c. Préférentiellement, les étapes b et c sont alternées. Toutefois, deux étapes b (identiques ou non) et / ou deux étapes c (identiques ou non) successives (l'une sur l'autre) peuvent être réalisées. Suivant les applications envisagées, les paramètres du procédé sont adaptés pour sélectivement modifier l'épaisseur et le matériau de chaque couche (mécanique ou fonctionnelle).

Un exemple de séquence du procédé selon l'invention avec les étapes b et c combinée est présenté ci-dessous :
- initialisation : paramétrage de l'enceinte (pression, température, purge avec un gaz inerte, etc.) afin notamment d'avoir une atmosphère contrôlée non réactive avec les produits qui seront utilisés lors du procédé ;
- première injection : Introduction d'un premier précurseur sous forme de gaz de type métallique (par exemple triméthylaluminium (TMA, Al₂(CH₃)₆) ou tétrachlorure de titane (TiCI₄)) pendant 0,1 à 60 s (seconde) à des débits allant de 1 à 1000 sccm. Ce premier précurseur va s'absorber sur la surface et adhérer en formant des liaisons métalliques avec des groupements résiduels (par exemple : amine ou hydroxyle) ;
- première purge : Une fois que la surface est saturée en premier précurseur, il faut purger l'enceinte avec un gaz inerte (par exemple argon (Ar) ou azote (N₂)) pendant 1 à 360 s ;
- deuxième injection : Introduction du deuxième précurseur sous forme de gaz de type inorganique (par exemple : eau (H₂O)) pendant 0,1 à 60 s à des débits allant de 1 à 1000 sccm. Ce deuxième précurseur va s'adsorber sur la surface et adhérer en formant des liaisons avec les sites métalliques du premier précurseur ;
- deuxième purge : Une fois que la surface est saturée en deuxième précurseur, il faut purger l'enceinte avec un gaz inerte (par exemple argon (Ar) ou azote (N₂)) pendant 5 à 360 s ;
- troisième injection : Introduction d'un troisième précurseur sous forme de gaz de type métallique (par exemple triméthylaluminium (TMA, Al₂(CH₃)₆) ou tétrachlorure de titane (TiCl₄)) pendant 0,1 à 60 s (seconde) à des débits allant de 1 à 1000 sccm. Ce troisième précurseur va s'absorber sur la surface et adhérer en formant des liaisons métalliques avec des groupements résiduels (par exemple : amine ou hydroxyle) ;
- troisième purge : Une fois que la surface est saturée en troisième précurseur, il faut purger l'enceinte avec un gaz inerte (par exemple argon (Ar) ou azote (N₂)) pendant 1 à 360 s ;
- quatrième injection : Introduction du quatrième précurseur sous forme gazeux de type organique (par exemple éthylène glycol (EG, C₂H₆O₂) ou hydroquinone (HQ, C₆H₄(OH)₂) pendant 0,1 à 60 s à des débits allant de 1 à 1000 sccm. Ce quatrième précurseur va s'absorber sur la surface et adhérer en formant des liaisons avec les sites métalliques du troisième précurseur ;
- quatrième purge : Une fois que la surface est saturée en quatrième précurseur, il faut purger l'enceinte avec un gaz inerte (par exemple argon (Ar) ou azote (N₂)) pendant 1 à 360 s.

Le processus cyclique peut ensuite être répété pour monter en épaisseur et former des dépôts allant de quelques ångström (0,1 nm) à 500 nm. Les cycles peuvent avoir plusieurs têtes.

Le rapport entre étape b et étape c permet de modifier les propriétés du revêtement 20. Le rapport entre étape b et étape c peut être par exemple permettre des épaisseurs sur l'épaisseur totale de dépôt selon, par exemple, des rapports 2:1, 10:1, 100:1, 1:1, 1:2, 1:100, etc.

Les étapes b et c alternées ont montré une résistance au travail en flexion avec des rayons de courbures allant de 1 à 10 cm sans propager de fissures suffisamment importantes pour compromettre l'étanchéité du revêtement 20.

L'invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées et/ou interchangées pour fournir d'autres réalisations. À titre nullement limitatif, il peut être envisagé d'autres variantes de revêtement 20 mélangeant par exemple deux variantes prévues dans les figures 6 à 11 sans sortir du cadre de l'invention.

En outre, le revêtement comporte au moins deux couches, c'est-à-dire fonctionnelle 20A et / ou hybride 20C et / ou mécanique 20B, pour générer au moins une couleur par effet interférentiel afin de décorer selon une couleur prédéterminée le composant 1 horloger.

Enfin, l'invention ne saurait se limiter à une pièce d'horlogerie. Ainsi, l'invention pourrait également être appliquée dans d'autres domaines tels que, par exemple, la bijouterie, la joaillerie, la maroquinerie, les arts de la table, les instruments d'optique, les armes à feu ou les instruments d'écriture.

### LISTE DES RÉFÉRENCES

- 1 -: composant horloger
- 1A -: composant horloger d'habillage
- 1B -: composant horloger de mouvement
- 2 -: pièce d'horlogerie
- 3 -: mouvement horloger
- 10 -: substrat
- 20 -: revêtement
- 20A -: couche fonctionnelle
- 20B -: couche mécanique
- 20C -: couche hybride
- 30 -: couche externe
- 30A -: couche fonctionnelle
- 30B -: couche mécanique
- 30C -: couche hybride
- 40 -: couche interne
- 40A -: couche fonctionnelle
- 40B -: couche mécanique
- 40C -: couche hybride
- B -: bris
- C -: couche d'alumine
- S -: substrat

## Revendications

1. Composant horloger (1) formé d'un substrat (10) qui est au moins partiellement recouvert par un revêtement (20), **caractérisé en ce que** ledit revêtement comporte au moins une couche (20A) fonctionnelle, déposée par méthode MLD, à base d'un matériau organique afin d'améliorer la durabilité dudit revêtement (20).

2. Composant horloger (1) formé d'un substrat (10) qui est au moins partiellement recouvert par un revêtement (20), **caractérisé en ce que** ledit revêtement comporte au moins une couche (20C) hybride, déposée par une méthode hybride MLD/ALD, à base d'un matériau organique et d'un matériau inorganique afin d'améliorer la durabilité dudit revêtement (20).

3. Composant horloger (1) selon la revendication 1 ou 2, dans lequel le matériau organique comporte une chaîne avec au moins deux atomes de carbone afin d'apporter une flexibilité au revêtement (20).

4. Composant horloger (1) selon l'une quelconque des revendications précédentes, dans lequel le matériau organique comporte au moins un site fonctionnel sur au moins une terminaison.

5. Composant horloger (1) selon la revendication précédente, dans lequel ledit au moins un site fonctionnel comporte une polyurée, une glycine, un glucose, un alcane, un alcool, un acide carboxylique, un organosilane, une organosilicone ou un composé perfluoré afin de former un revêtement (20) hydrophile, hydrophobe et / ou lipophobe.

6. Composant horloger (1) selon l'une quelconque des revendications précédentes, dans lequel le revêtement (20) comporte en outre au moins une couche (20B) mécanique, déposée par méthode ALD, à base d'un matériau inorganique afin d'améliorer la résistance mécanique et / ou la qualité optique dudit revêtement (20).

7. Composant horloger (1) selon l'une quelconque des revendications précédentes, dans lequel chaque couche (20B) mécanique est à base de céramique.

8. Composant horloger (1) selon l'une quelconque des revendications précédentes, formant un cadran, un spiral, une roue ou une aiguille.

9. Composant horloger (1) selon l'une quelconque des revendications précédentes, dans lequel le revêtement (20) comporte au moins deux couches (20A, 20B, 20C) pour générer au moins une couleur par effet interférentiel.

10. Procédé de fabrication d'un composant horloger (1) comportant un substrat (10) au moins partiellement recouvert par un revêtement (20), **caractérisé en ce que** le procédé comporte les étapes suivantes :
a. former le substrat (10) du composant horloger (1) ;
b. déposer, par une méthode MLD, au moins une couche (20A) fonctionnelle à base d'au moins un précurseur d'un matériau organique sur le substrat (10) afin d'améliorer la durabilité dudit revêtement (20).

11. Procédé de fabrication d'un composant horloger (1) comportant un substrat (10) au moins partiellement recouvert par un revêtement (20), **caractérisé en ce que** le procédé comporte les étapes suivantes :
a. former le substrat (10) du composant horloger (1) ;
b. déposer, par une méthode hybride MLD/ALD, au moins une couche (20C) hybride à base d'au moins un précurseur d'un matériau organique et d'au moins un précurseur d'un matériau inorganique sur le substrat (10) afin d'améliorer la durabilité dudit revêtement (20).

12. Procédé de fabrication selon la revendication 10 ou 11, dans lequel ledit au moins un précurseur dudit matériau organique comporte une chaîne avec au moins deux atomes de carbone afin d'apporter une flexibilité au revêtement (20).

13. Procédé de fabrication selon l'une quelconque des revendications 10 à 12, dans lequel ledit au moins un précurseur dudit matériau organique comporte au moins un site fonctionnel sur au moins une terminaison.

14. Procédé de fabrication selon la revendication précédente, dans lequel ledit au moins un site fonctionnel comporte une amine, un thiol, un hydroxyle, un époxyde, un acide carboxylique, un acrylate, un silane ou un organosilane afin d'améliorer l'adhérence du revêtement (20).

15. Procédé de fabrication selon la revendication 13 ou 14, dans lequel ledit au moins un site fonctionnel comporte une polyurée, une glycine, un glucose, un alcane, un alcool, un acide carboxylique, un organosilane, une organosilicone ou un composé perfluoré afin de former un revêtement (20) hydrophile, hydrophobe et / ou lipophobe.

16. Procédé de fabrication selon l'une quelconque des revendications 10 à 15, dans lequel ledit précurseur dudit matériau organique est à base de 4-aminophénol, 1,4-butanediol, 1,6-hexanediol, d'éthylène glycol, d'hydroquinone, d'acide benzènedicarboxylique ou d'éthylanoamine.

17. Procédé de fabrication selon l'une quelconque des revendications 10 à 16, comportant en outre l'étape suivante :
c. déposer, par méthode ALD, au moins une couche (20B) mécanique à base d'un précurseur d'un matériau inorganique afin d'améliorer la résistance mécanique et / ou la qualité optique dudit revêtement (20).

18. Procédé de fabrication selon la revendication précédente, comportant plusieurs étapes b et / ou plusieurs étapes c.
